# EUROPÄISCHE PATENTSCHRIFT

(11) **EP 1 630 913 B1**
(45) Veröffentlichungstag und Bekanntmachung des Hinweises auf die Patenterteilung: **03.10.2007**
(21) Anmeldenummer: 04090336.1
(22) Anmeldetag: 31.08.2004
(51) Int. Cl.: H01S 5/022, B23K 26/18

(54) **Verfahren zum Herstellen eines mit einem Kunststoffgehäuse versehenen optischen oder elektronischen Moduls das eine optische oder elektronische Komponente enthält, sowie optisches oder elektronisches Modul**
Method for manufacturing an optical or electronic modul with a plastic casing containing an optical or electronic component as well as said optical or electronic modul
Méthode de fabrication d'un module électronique ou optique dans un boîtier en matière plastique contenant un composant électronique ou optique ainsi que ledit module optique ou électronique

(43) Veröffentlichungstag der Anmeldung: 01.03.2006
(73) Patentinhaber: Infineon Technologies AG, 81669 München (DE)
(72) Erfinder: Hurt, Hans, 93049 Regensburg (DE); Wittl, Josef, 92331 Parsberg (DE); Weberpals, Frank, 93047 Regensburg (DE); Schunk, Nikolaus, 93142 Maxhütte-Haidhof (DE); Auburger, Albert, 93128 Regenstauf (DE); Paulus, Stefan, 93197 Zeitlarn (DE); Prucker, Stephan, 93133 Burglengenfeld (DE)
(74) Vertreter: Dilg, Andreas

(56) Entgegenhaltungen:
- DE-A1- 10 154 017
- DE-A1- 19 909 242
- US-A1- 2003 141 510

## Beschreibung

Die Erfindung betrifft ein Verfahren zum Herstellen eines mit einem Kunststoffgehäuse versehenen optischen oder elektronischen Moduls, bei dem eine mit der Umgebung in Wirkverbindung stehende Komponente nach dem Umhüllen der Modulkomponenten mit einer Kunststoffmasse in einem sich daran anschließenden Verfahrensschritt teilweise wieder freigelegt wird. Des weiteren betrifft die Erfindung ein entsprechendes optisches oder elektronisches Modul.

Es ist bekannt, optoelektronische Module mit einem transparenten Vergussmaterial zu vergießen. So ist beispielsweise aus der DE 199 09 242 A1 ein opto-elektronisches Modul bekannt, bei dem ein Leadframe mit einem opto-elektronischen Wandler in einem Modulgehäuse positioniert und mit einem lichtdurchlässigen, formbaren Kunststoffmaterial vergossen wird. Eine Lichtein- oder Auskopplung erfolgt über eine Lichtleitfaser, die an einem Stutzen des Modulgehäuses angekoppelt wird. Auf dem Leadframe befindet sich auch der Treiberbaustein bzw. Empfangsbaustein für den opto-elektronischen Wandler.

Weiter ist aus dem Dokument DE 101 54 017 A1 ein Verfahren zum Schutz einer kunststoffgehäusten elektronischen Baugruppe bekannt. Nach dem beschriebenen Verfahren wird eine elektronische Baugruppe bei der Öffnung des Gehäuses durch Laserabtrag mittels einer Schutzschicht vor Einwirkung des Lasers geschützt.

Allerdings weist die Verwendung von Vergussmaterialien, die für den jeweiligen Wellenlängenbereich transparent sind, insofern Nachteile auf, als transparente Vergussmaterialien in der Regel einen hohen thermischen Ausdehnungskoeffizienten besitzen und dementsprechend bei großen Temperaturschwankungen Spannungen im Package auftreten, die insbesondere die empfindlichen Bonddraht-Verbindungen beschädigen können.

Es ist daher grundsätzlich vorteilhaft, für ein Vergießen oder Verpressen der Komponenten eines Moduls nichttransparente Kunststoffmaterialien einzusetzen, die mit Füllstoffen versehen sind, die einen günstigen thermischen Ausdehnungskoeffizienten des Kunststoffmaterials bereitstellen. Nachteilig bei der Verwendung solcher Kunststoffe als Vergussmaterial ist, dass innerhalb des Vergussmaterials kein optischer Pfad realisiert werden kann.

Der vorliegenden Erfindung liegt die Aufgabe zu Grunde, ein effektives Verfahren zum Herstellen eines mit einem Kunststoffgehäuse versehenen optischen oder elektronischen Moduls sowie ein optisches oder elektronisches Modul bereitzustellen, die es ermöglichen, eine vergossene Komponente des Moduls in Wirkverbindung mit der Umgebung zu bringen.

Diese Aufgabe wird erfindungsgemäß durch ein Verfahren mit den Merkmalen des Anspruchs 1 und ein optisches oder elektronisches Moduls mit den Merkmalen des Anspruchs 20 gelöst. Bevorzugte und vorteilhafte Ausgestaltungen der Erfindung sind in den Unteransprüchen angegeben.

Dabei zeichnet sich die erfindungsgemäße Lösung dadurch aus, dass eine Schutzschicht auf die Komponente aufgebracht wird, die zumindest den Wirkbereich der Komponente abdeckt. Die Schutzschicht ist dabei für die von der Laser-Abtragvorrichtung ausgesandte Strahlung nicht transparent, so dass die Komponente vor der Strahlung der Laser-Abtragvorrichtung sicher geschützt wird. Insbesondere wird verhindert, dass Licht der Laser-Abtragvorrichtung in die Komponente eindringen und Beschädigungen hervorrufen kann.

Die Kunststoffmasse wird zwischen der Schutzschicht und der Außenseite des Kunststoffgehäuses durch die Laser-Abtragvorrichtung entfernt. Es ist also vorgesehen, die mit einer Schutzschicht versehene Komponente nach dem Umhüllen mit einem Kunststoffmaterial wieder freizulegen, d. h. dass sie abdeckende Kunststoffmaterial wieder zu entfernen, damit sie in Wirkverbindung mit der Umgebung treten kann. Die vorliegende Erfindung basiert auf dem Gedanken, eine LaserStoppschicht bereit zu stellen, die eine Beschädigung der Komponente durch Laserlicht verhindert, die von der Laser-Abtragvorrichtung zur Ausbildung einer Öffnung in der Kunststoffmasse ausgesandt wird.

Das Aufbringen der Schutzschicht kann z. B. durch einen Standard-Wafer Prozess vor Vereinzelung der Komponenten oder am einzelnen Bauelement etwa mit Hilfe eines Dosiervorgangs realisiert werden.

Das erfindungsgemäße optische oder elektronische Modul zeichnet sich durch eine auf die optische oder elektronische Komponente aufgebrachte Schutzschicht auf, die zumindest den Wirkbereich der Komponente abdeckt. Die Schutzschicht ist dabei für Strahlungen der Wellenlänge, mit der eine Laser-Abtragvorrichtung eine Laserabtragöffnung in dem Kunststoffgehäuse zwecks Freilegung des Wirkbereichs der Komponente ausgebildet hat, reflektierend ausgebildet. Die Schutzschicht verbleibt auf der Komponente, auch nachdem die Laserabtragöffnung in das Kunststoffgehäuse eingebracht ist.

Es wird darauf hingewiesen, dass das erfindungsgemäße Verfahren sowohl Ausgestaltungen umfasst, bei denen die Schutzschicht nach Ausbilden der Laserabtragöffnung auf der Komponente verbleibt, als auch Ausgestaltungen, bei denen die Schutzschicht nach Ausbildung der Laserabtragöffnung durch einen geeigneten Prozess, z. B. chemisch wieder abgetragen wird. In letzterem Fall ist die Schutzschicht in dem fertigen Modul nicht mehr enthalten.

Die Schutzschicht kann unterschiedliche Geometrien besitzen. In einer bevorzugten Ausgestaltung ist die Schutzschicht als planare Schicht ausgebildet. Die Schutzschicht kann beispielsweise jedoch auch durch einen Tropfen bereitgestellt werden, der auf den Wirkbereich der Komponente aufgebracht wird und dann erhärtet.

Die Schutzschicht ist in einer bevorzugten Ausgestaltung als Schichtsystem, beispielsweise als Schichtsystem mit mindestens einer Metallschicht oder mindestens einer Kunststoffschicht ausgebildet.

Unter einem Wirkbereich der optischen oder elektrischen Komponente wird jeder Bereich bezeichnet, der eine Wirkverbindung der Komponente mit der Umgebung ermöglicht. Beispielsweise handelt es sich um den photosensitiven Bereich einer Photodiode, um den Sensorbereich eines Drucksensors oder eines Temperatursensors, um den lichtemittierenden Bereich eines Halbleiterlasers oder einer LED oder um die der Modul-Außenseite zugewandte Fläche einer Linse, eines Spiegels oder eines Prismas.

In einer bevorzugten Ausgestaltung ist die Komponente eine optische Komponente, die über den Wirkbereich Licht einer bestimmten Wellenlänge emittiert oder detektiert. Dabei ist die Schutzschicht für Licht der emittierten oder detektierten Wellenlänge transparent, nicht dagegen für die Strahlung der Laser-Abtragvorrichtung. Um dies zu erreichen, ist die Schutzschicht beispielsweise als Interferenzfilter ausgebildet.

In einer bevorzugten Ausgestaltung wird die optische oder elektronische Komponente vor dem Umhüllen mit Kunststoff durch elektrische Verbindungen, insbesondere mittels Bonddrähten elektrisch kontaktiert. Dabei liegen die elektrischen Verbindungen bevorzugt in einem Bereich der Kunststoffmasse, in dem ein partielles Entfernen der Kunststoffmasse nicht erfolgt. Die Bonddrähte können daher bei dem Freilegen der Komponente nicht beschädigt werden.

Die optische oder elektronische Komponente wird bevorzugt vor dem Umhüllen auf einem Träger angeordnet. Der Träger des Moduls ist bevorzugt als Leadframe, auch als Metallträger oder Stanzgitter bezeichnet, ausgebildet. Das Leadframe weist dabei bevorzugt mindestens einen planen Trägerbereich, auch als "die pad" oder "Chipinsel" bezeichnet, sowie eine Mehrzahl von Kontaktbeinen auf, die sich am Randbereich des Leadframes befinden. Die optische oder elektronische Komponente wird dabei jeweils auf einem Trägerbereich angeordnet. Grundsätzlich können statt eines Leadframes aber auch beliebige andere Träger eingesetzt werden, beispielsweise Träger, die aus einer strukturierten Kunststofffolie bestehen oder aus einer Leiterplatte. Auch kann auf einen gesonderten Träger grundsätzlich ganz verzichtet werden.

Die optische Komponente ist bevorzugt ein opto-elektronisches Sendebauelement oder ein opto-elektronisches Empfangsbauelement, insbesondere eine Photodiode oder eine LED oder ein Halbleiterlaser. Sofern es sich bei der Komponente um eine elektronische Komponente handelt, ist diese bevorzugt ein Sensor, insbesondere ein Drucksensor oder ein Temperatursensor.

Der Schritt des Umhüllens mit Kunststoffmasse umfasst bevorzugt ein Vergießen oder Verpressen der Komponente mit der Kunststoffmasse. Das Vergießen oder Verpressen kann dabei in einem speziellen Werkzeug, insbesondere einem Spritzgusswerkzeug erfolgen.

Die Erfindung wird nachfolgend unter Bezugnahme auf die Figuren anhand eines Ausführungsbeispieles näher erläutert.
Es zeigen:
- Figur 1: eine Schnittansicht eines optischen Moduls mit einer optischen Komponente während der Herstellung des Moduls und nach Vergießen des Moduls mit einer Kunststoffmasse; und
- Figur 2: das fertige optische Modul, hergestellt nach dem Verfahren der vorliegenden Erfindung.

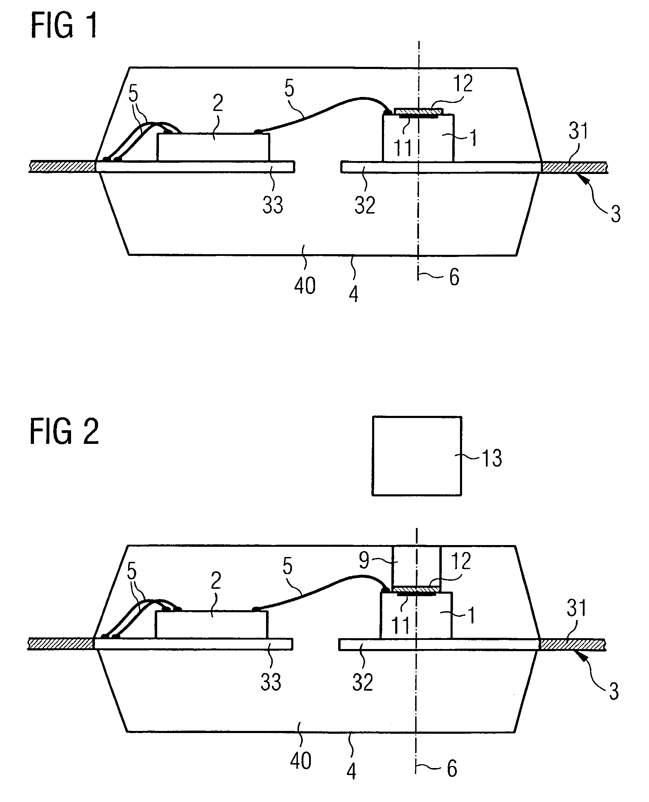

Die Figur 1 zeigt ein optisches Modul mit einer optischen Komponente 1 und einem zugeordneten elektronischen Baustein 2, die auf einem Leadframe 3 angeordnet und mit einer nicht transparenten Kunststoffmasse 40, die ein Kunststoffgehäuse 4 bereitstellt, vergossen sind.

Bei der optischen Komponente 1 handelt es sich beispielsweise um eine Lumineszenzdiode (LED), einen Halbleiterlaser oder eine Photodiode. Bei dem elektronischen Baustein 2 handelt es sich beispielsweise um einen Treiber oder einen Vorverstärker. Die optische Komponente 2 ist bevorzugt als vorgefertigter Chip ausgebildet. Der elektronische Baustein 2 ist bevorzugt als integrierter Schaltkreis (IC) ausgebildet.

Der Leadframe 3 weist zwei plane Trägerflächen 32, 33 auf, die auch als "die pad" bezeichnet werden und auf denen zum einen die optische Komponente 1 und zum anderen der elektronische Baustein 2 angeordnet sind. Des weiteren besitzt der Leadframe 3 an seinem Rand eine Mehrzahl von Kontaktbeinen (leads). Die Kontaktbeine stehen dabei aus der Vergussmasse 4 hervor. Derartige Leadframes 3 sind im Stand der Technik bekannt, so dass hierauf nicht weiter eingegangen wird.

Auf den beiden Trägerflächen 32, 33 sind die optische Komponente 1 und der elektronische Baustein 2 angeordnet. Eine elektrische Kontaktierung dieser Modulkomponenten 1, 2 erfolgt zum einen durch einen Kontakt auf der Unterseite, der direkt mit der jeweiligen Trägerfläche 32, 33 elektrisch verbunden ist, sowie zum anderen über Bonddrähte 5.

Die optische Komponente 1 weist an ihrer Oberseite eine Wirkfläche 11 auf. Beispielsweise handelt es sich um eine lichtemittierende Fläche 11 eines LED-Chips.

Die Kunststoffmasse 40 ist zur Bereitstellung eines günstigen thermischen Ausdehnungskoeffizienten mit einem Füllstoff versehen und daher nicht transparent für das emittierte oder empfangene Licht. Der optische Pfad des optischen Bauelements 1 ist verschlossen.

Es ist daher vorgesehen, in einem weiteren Verfahrensschritt eine Öffnung 9 in die Kunststoffmasse 40 einzubringen, so dass die Wirkfläche 11 der optischen Komponente 1 freigelegt und die optische Komponente 1 in Wirkverbindung mit der Umgebung treten kann. Das entsprechend fertig gestellte Modul ist in der Figur 2 dargestellt.

Zur Ausbildung einer Öffnung 9 in der Kunststoffmasse 40 ist die Verwendung einer Laser-Abtragvorrichtung 13 vorgesehen, die in der Figur 2 als Funktionsblock dargestellt ist. Die Laser-Abtragvorrichtung 13 umfasst in einer beispielhaften Ausgestaltung einen Laser, beispielsweise einen Nd:YAG-Laser, der Licht einer Wellenlänge von 1064 nm emittiert, sowie eine dem Laser zugeordnete Spiegeltrommel. Der Laser ist dabei derart angeordnet, dass der vom Laser emittierte Strahl auf die sich drehende Spiegeltrommel fällt. Die Spiegeltrommel weist einen polygonalen Querschnitt auf, so dass beim Drehen der Spiegeltrommel um eine horizontale Längsachse der Laserstrahl in einem begrenzten Laserstrahlbereich abgelenkt wird, wobei sich die Öffnung 9 in der nicht transparenten Kunststoffmasse 40 bildet. Durch geeignete Spiegelflächen der Spiegeltrommel wird dabei erreicht, dass der Laserstrahl sich flächig auf der Kunststoffmasse erstreckt, so dass eine dreidimensionale Laserabtragöffnung in dem Kunststoffgehäuse 4 eingegraben wird.

Abhängig von der genauen Ausgestaltung der Laser-Abtragvorrichtung kann die Öffnung 9 dabei unterschiedliche Ausgestaltungen aufweisen. In der Regel wird die in der Figur 2 lediglich schematisch dargestellte Laserabtragöffnung 9 trichterförmig ausgebildet sein.

Die Ausbildung einer Öffnung 9 im Kunststoffgehäuse unter Verwendung einer Laser-Abtragvorrichtung weist den Vorteil auf, dass eine Öffnung mit hoher Präzision in die Kunststoffmasse 40 eingebracht werden kann.

Allerdings besteht bei der Verwendung eines Lasers zur Ausbildung der Öffnung 9 in dem Gehäuse 4 die Gefahr, dass durch den Laserstrahl selbst oder aufgrund von hohen Temperaturen, die sich aus dem Abtrag der Kunststoffmasse mittels des Laserstrahls ergeben, die Komponente 1 beschädigt wird. Insbesondere ist zu verhindern, dass das Laserlicht der Laser-Abtragvorrichtung in die optische Komponente 1 bzw. deren Wirkbereich 11 eindringt und Beschädigungen hervorruft.

Zur Verhinderung solcher Beschädigungen ist vorgesehen, auf der dem Gehäuseäußeren zugewandten Fläche der Komponente 1 eine Schutzschicht 12 anzubringen. Die Schutzschicht 12 deckt dabei bevorzugt zumindest den Wirkbereich 11 der Komponente 1 ab.

Es bestehen mehrere Ausführungsvarianten treffend die Anbringung und Ausgestaltung der Schutzschicht 12.

In einer ersten Ausführungsvariante ist die Schutzschicht als Reflexionsschicht 12 ausgebildet, die Licht der Wellenlänge, die die Laser-Abtragvorrichtung 13 aussendet, reflektiert. Dies führt dazu, dass nach Abtragen des Kunststoffmaterials, das zwischen der Reflexionsschicht 12 und der Außenseite des Kunststoffgehäuses 4 ausgebildet ist, der Vorgang des Freilegens der optischen Komponente 1 automatisch beendet ist. Ein weiterer Abtrag wird durch die Reflexionsschicht 12 verhindert. Dabei kann zusätzlich vorgesehen sein, dass die Laser-Abtragvorrichtung 13 überwacht, ob sie ein reflektiertes Signal detektiert, und für diesen Fall den Laserabtrag beendet. Das an der Reflexionsschicht 12 reflektierte Licht wird somit zur Erzeugung eines Regelsignals betreffend die Regelung des Laserabtrags verwendet.

Allerdings ist es bei der Ausgestaltung der Schutzschicht 12 als Reflexionsschicht - jedenfalls für den Fall der Ausgestaltung der Komponente 1 als optoelektronische Komponente - erforderlich, dass die Reflexionsschicht 12 zwar das von der Laserabtragrichtung 13 erzeugte Licht reflektiert, für das von der Komponente 1 emittierte oder zu detektierende Licht jedoch transparent ist. Hierzu ist die Reflexionsschicht 12 bevorzugt als Interferenzfilter ausgebildet, der lediglich für das von der Komponente 1 ausgesandte Licht oder das von der Komponente 1 zu detektierende Licht durchlässig ist, andere Wellenlängen dagegen reflektiert. Ein solcher Interferenzfilter kann als Schichtsystem aus Kunststoffschichten oder Metallschichten in an sich bekannter Weise ausgebildet sein.

Sofern es sich bei der Komponente 1 beispielsweise um eine Fotodiode handelt, die Licht einer bestimmten Wellenlänge von beispielsweise 650 nm, 850 nm, 1310 nm oder 1550 nm detektiert, so wird als Schutzschicht 12 ein Interferenzfilter verwendet, der für die entsprechende Wellenlänge transparent ist. Für das von der Laser-Abtragvorrichtung 13 ausgesandte Licht (das bei einem beispielsweise verwendeten Nd:YAG-Laser eine Wellenlänge von 1064 nm aufweist) ist der Interferenzfilter dagegen nicht transparent und hoch reflektierend. Hierdurch wird sichergestellt, dass die freizulegende Komponente 1 durch das Licht der Laser-Abtragvorrichtung 13 nicht beschädigt wird.

In einem anderen Ausführungsbeispiel dieser ersten Erfindungsvariante ist die Komponente 1 eine LED oder ein Halbleiterlaser, wobei die Reflexionsschicht 12 einen Aufbau derart besitzt, dass zwar das Licht der Laser-Abtragvorrichtung 13 reflektiert wird, gleichzeitig jedoch das in entgegengesetzter Richtung die Reflexionsschicht 12 durchtretende Licht des Lasers bzw. der LED durchgelassen wird.

In beiden Fällen ist es erforderlich, dass sich die Wellenlänge der Laser-Abtragvorrichtung und die Wellenlänge des detektierten bzw. emittierten Lichtes ausreichend unterscheiden, um eine Trennung der Transmissionseigenschaften sicherzustellen.

Bei der Ausbildung der Schutzschicht 12 als Reflexionsschicht ist es möglich, dass die Reflexionsschicht nach Ausbilden der Öffnung 9 in dem Kunststoffgehäuse 4 und nach dem damit einhergehenden Freilegen der optischen Komponente 1 auf dieser verbleibt. Hierdurch wird ein zusätzlicher Verfahrensschritt eines Entfernens der Schutzschicht 12 vermieden. Auch kann die auf der Komponente 1 verbleibende Schutzschicht dazu beitragen, die Komponente 1 und deren Wirkfläche 11 vor äußeren Einflüssen wie Schmutz und Staub zu schützen.

In einer zweiten Ausführungsvariante ist davon abweichend vorgesehen, dass die Schutzschicht 12 zwar als Reflexionsschicht ausgebildet ist, nach dem Ausbilden einer Öffnung 9 in dem Kunststoffgehäuse 4 jedoch wieder entfernt wird, beispielsweise mittels einer Ätzflüssigkeit, eines Ätzgases oder eines anderen geeigneten Verfahrens. Für diesen Fall ist es nicht erforderlich, dass die Reflexionsschicht für das Licht der emittierten bzw. zu detektierenden Wellenlänge transparent ist, da die Schutzschicht beim Betrieb des Moduls nicht mehr vorhanden ist.

Einer dritten Ausführungsvariante ist die Schutzschicht 112 (die auch als Laserstoppschicht bezeichnet werden kann) nicht als Reflexionsschicht ausgebildet. Es handelt sich für diesen Fall insbesondere um eine Schicht aus einem Material, das eine im Vergleich zu der Kunststoffmasse 40 geringere Laserabtragrate aufweist. Sofern der Laserstrahl der Laser-Abtragvorrichtung somit in den Bereich der Schutzschicht 12 vordringt, erfolgt ein Abtragen der Schutzschicht 12 mit deutlich reduzierter Geschwindigkeit. Selbst für den Fall, dass das Abtragen des Kunststoffmaterials 40 mittels der Laser-Abtragvorrichtung 13 mit einer gewissen Toleranz versehen ist und die Abtragtiefe nicht mit extremer Genauigkeit eingestellt werden kann, wird auf diese Weise verhindert, dass die Strahlung der Laser-Abtragvorrichtung 13 auf die Komponente 1 bzw. deren Wirkfläche 1 fallen und diese dabei beschädigen kann. Die Schutzschicht 12 ist dabei natürlich nichttransparent ausgebildet. Nach der Ausbildung der Laserabtragöffnung 9 in dem Kunststoffgehäuse 4 wird die Schutzschicht bei dieser Ausführungsvariante wieder entfernt. Dies erfolgt wie bereits erwähnt beispielsweise mittels einer Ätzflüssigkeit oder eines Ätzgases.

Die Verwendung einer Schutzschicht ermöglicht es, auch relativ einfach und mit relativ geringer Präzision arbeitende Verfahren zur Realisierung eines Laserabtrags in der Kunststoffschicht 40 einzusetzen, da die Beschädigung der Komponente 1 durch die Schutzschicht 12 sicher verhindert wird. Die Verfahren und entsprechenden Laser-Abtragvorrichtungen 13 können daher kostengünstig ausgestaltet sein.

Es wird darauf hingewiesen, dass die Öffnung 9 nach ihrer Ausbildung grundsätzlich mit einem Füllmaterial mit gewünschten Eigenschaften, beispielsweise einem transparenten Material zumindest teilweise wieder aufgefüllt werden kann. Ein solches transparentes Material kann beispielsweise zwecks seiner zusätzlichen Versiegelung der Komponente 1 gegenüber der Umgebung vorgesehen sein.

Es wird weiter darauf hingewiesen, dass die Komponente 1 auch eine elekronische Komponente sein kann. Es kann es sich bei der Komponente 1 beispielsweise um einen Sensor-Chip handeln, insbesondere um einen Drucksensor oder einen Temperatursensor, wie sie in der Automobilindustrie Anwendung findet. Für den Fall, dass es sich bei der Komponente 1 um einen Drucksensor handelt, ist das erwähnte Füllmaterial bevorzugt gummielastisch ausgebildet, so dass es auftretende Drücke an die Komponente 1 weiterleiten kann, ohne dabei die Druckmessung zu verfälschen.

Des Weiteren wird darauf hingewiesen, dass das Modul mehrere optische oder elektronische Komponenten der beschriebenen Art aufweisen kann, wobei dann für jede der Komponenten eine zusätzliche Schutzschicht 12 vorgesehen ist.

Die Herstellung des optischen oder elektronischen Moduls erfolgt bevorzugt im Nutzen auf einem Multinest-Werkzeug, wobei nach Aushärten des Kunststoffmaterials sowie nach Freilegen der jeweiligen Komponenten die einzelnen optischen oder elektronischen Module vereinzelt werden.

## Patentansprüche

1. Verfahren zum Herstellen eines mit einem Kunststoffgehäuse versehenen optischen oder elektronischen Moduls, mit folgenden Schritten:
- Bereitstellen mindestens einer optischen Komponente (1), die einen Wirkbereich (11) aufweist, über den sie im fertigen Modul Licht einer bestimmten Wellenlänge emittiert oder detektiert,
- Aufbringen einer Schutzschicht (12) auf die Komponente (1), die zumindest den Wirkbereich (11) der Komponente (1) abdeckt,
- Umhüllen der mindestens einen Komponente (1) mit mindestens einer Kunststoffmasse (40) zur Ausbildung des Kunststoffgehäuses (4), und
- partielles Entfernen der Kunststoffmasse (40) von außen durch eine Laser-Abtragvorrichtung (13) derart, dass die Kunststoffmasse (40) zwischen der Schutzschicht (12) der Komponente (1) und der Außenseite des Kunststoffgehäuses (4) entfernt wird, so dass eine Laserabtragsöffnung (9) entsteht,
- wobei die Schutzschicht (12) die von der Laser-Abtragvorrichtung (13) ausgesandte Strahlung reflektiert, für Licht der von der optischen Komponente emittierten oder detektierten Wellenlänge jedoch transparent ist und
- die Schutzschicht (12) nach dem partiellen Entfernen der Kunststoffmasse (40) auf der Komponente (1) verbleibt.

2. Verfahren nach Anspruch 1, **dadurch gekennzeichnet, dass** die Schutzschicht (12) eine im Vergleich zu der Kunststoffmasse (40) des Kunststoffgehäuses geringere Laser-Abtragrate aufweist.

3. Verfahren nach Anspruch 1, **dadurch gekennzeichnet, dass** die Komponente (1) ein opto-elektronisches Sendebauelement ist, wobei die Schutzschicht (12) für Licht der emittierten Wellenlänge transparent ist, während sie für die von der Laser-Abtragvorrichtung (13) ausgesandte Strahlung reflektierend ist.

4. Verfahren nach Anspruch 1, **dadurch gekennzeichnet, dass** die Komponente (1) ein opto-elektronisches Empfangsbauelement ist, wobei die Schutzschicht (12) für Licht der zu detektierenden Wellenlänge transparent ist, während sie für die von der Laser-Abtragvorrichtung (13) ausgesandte Strahlung reflektierend ist.

5. Verfahren nach mindestens einem der Ansprüche 1 bis 4, **dadurch gekennzeichnet, dass** die emittierte oder detektierte Wellenlänge im Bereich von 650 nm, 850 nm, 1310 nm oder 1550 nm liegt.

6. Verfahren nach mindestens einem der Ansprüche 1 bis 4, **dadurch gekennzeichnet, dass** die von der Laser-Abtragvorrichtung (13) emittierte Strahlung eine Wellenlänge im Bereich von 1064 nm besitzt.

7. Verfahren nach mindestens einem der Ansprüche 1 bis 6, **dadurch gekennzeichnet, dass** die von der Schutzschicht (12) reflektierte Strahlung detektiert und aus der detektierten Strahlung ein Signal abgeleitet wird, das bewirkt, dass die Laser-Abtragvorrichtung (13) das Entfernen der Kunststoffmasse beendet.

8. Verfahren nach mindestens einem der vorangehenden Ansprüche, **dadurch gekennzeichnet, dass** die Schutzschicht (12) auf einen Wafer aufgebracht wird, bevor dieser unter Entstehung optischer oder elektronischer Komponenten (1) vereinzelt wird.

9. Verfahren nach mindestens einem der Ansprüche 1 bis 8, **dadurch gekennzeichnet, dass** die Schutzschicht (12) auf die ansonsten vorgefertigte einzelne Komponente (1) aufgebracht wird.

10. Verfahren nach mindestens einem der vorangehenden Ansprüche, **dadurch gekennzeichnet, dass** als Schutzschicht (12) ein Schichtsystem verwendet wird, das einen Interferenzfilter ausbildet.

11. Verfahren nach mindestens einem der vorangehenden Ansprüche, **dadurch gekennzeichnet, dass** als Schutzschicht (12) mindestens eine Metallschicht oder mindestens eine Kunststoffschicht verwendet wird.

12. Verfahren nach mindestens einem der vorangehenden Ansprüche, **dadurch gekennzeichnet, dass** die optische oder elektronische Komponente (1) vor dem Umhüllen auf einem Träger (3) angeordnet wird.

13. Verfahren nach Anspruch 12, **dadurch gekennzeichnet, dass** der Träger als Leadframe (3) ausgebildet ist, der zum einen mindestens einen planen Trägerbereich (32) und zum anderen eine Mehrzahl von Kontaktbeinen (31) aufweist, die sich am Randbereich des Leadframes befinden, und wobei die optische oder elektronische Komponente (1) jeweils auf einem Trägerbereich (32) angeordnet wird.

14. Verfahren nach mindestens einem der vorangehenden Ansprüche, **dadurch gekennzeichnet, dass** der Schritt des Umhüllens ein Vergießen oder Verpressen der mindestens einen Komponente (1) mit dem mindestens einen Kunststoffmaterial umfasst.

15. Optisches Modul mit
- mindestens einer optischen oder elektronischen Komponente (1), die einen Wirkbereich (11) aufweist, über den sie Licht einer bestimmten Wellenlänge emittiert oder detektiert,
- eine auf die Komponente (1) aufgebrachte Schutzschicht (12), die zumindest den Wirkbereich (11) der Komponente abdeckt, und
- einem Kunststoffgehäuse (4), in dem die Komponente (1) angeordnet ist, wobei
- das Kunststoffgehäuse (4) angrenzend an die Schutzschicht (12) eine Laserabtragöffnung (9) aufweist und der Wirkbereich (11) der Komponente (1) über die Laserabtragöffnung (9) in Wirkverbindung mit der Umgebung steht, und wobei
- die Schutzschicht (12) für Strahlung der Wellenlänge, mit der eine Laser-Abtragvorrichtung (13) die Laserabtragöffnung (9) in dem Kunststoffgehäuse (4) ausgebildet hat, reflektierend und für Licht der von der optischen Komponente emittierten oder detektierten Wellenlänge transparent ausgebildet ist.

16. Modul nach Anspruch 15, **dadurch gekennzeichnet, dass** die Schutzschicht (12) durch ein Schichtsystem gebildet ist, das einen Interferenzfilter ausbildet.

17. Modul nach mindestens einem der Ansprüche 15 oder 16, **dadurch gekennzeichnet, dass** die Schutzschicht (12) durch mindestens eine Metallschicht oder mindestens eine Kunststoffschicht gebildet ist.

## Claims

1. Method for producing an optical or electronic module provided with a plastic package, with the following steps:
- provision of at least one optical component (1), which has an operative region (11), via which it emits or detects light of a specific wavelength in the finished module,
- application to the component (1) of a protective layer (12), which covers at least the operative region (11) of the component (1),
- encapsulation of the at least one component (1) with at least one polymer compound (40) to form the plastic package (4), and
- partial removal of the polymer compound (40) from the outside by a laser ablation device (13) in such a way that the polymer compound (40) between the protective layer (12) of the component (1) and the outer side of the plastic package (4) is removed,
so that a laser-ablated opening (9) is created,
- the protective layer (12) reflecting the radiation emitted by the laser ablation device (13) but being transparent for light of the wavelength emitted or detected by the optical component, and
- after the partial removal of the polymer compound (40), the protective layer (12) remaining on the component (1).

2. Method according to Claim 1, **characterized in that** the protective layer (12) has a lower laser ablation rate in comparison with the polymer compound (40) of the plastic package.

3. Method according to Claim 1, **characterized in that** the component (1) is an optoelectronic transmitting component, the protective layer (12) being transparent for light of the wavelength emitted, while it is reflective for the radiation emitted by the laser ablation device (13).

4. Method according to Claim 1, **characterized in that** the component (1) is an optoelectronic receiving component, the protective layer (12) being transparent for light of the wavelength to be detected, while it is reflective for the radiation emitted by the laser ablation device (13).

5. Method according to at least one of Claims 1 to 4, **characterized in that** the wavelength emitted or detected lies in the range of 650 nm, 850 nm, 1310 nm or 1550 nm.

6. Method according to at least one of Claims 1 to 4, **characterized in that** the radiation emitted by the laser ablation device (13) has a wavelength in the region of 1064 nm.

7. Method according to at least one of Claims 1 to 6, **characterized in that** the radiation reflected by the protective layer (12) is detected and a signal causing the laser ablation device (13) to end the removal of the polymer compound is derived from the radiation detected.

8. Method according to at least one of the preceding claims, **characterized in that** the protective layer (12) is applied to a wafer before the latter is singulated, thereby producing optical or electronic components (1).

9. Method according to at least one of Claims 1 to 8, **characterized in that** the protective layer (12) is applied to the otherwise prefabricated individual component (1).

10. Method according to at least one of the preceding claims, **characterized in that** a system of layers which forms an interference filter is used as the protective layer (12).

11. Method according to at least one of the preceding claims, **characterized in that** at least one metal layer or at least one plastic layer is used as the protective layer (12).

12. Method according to at least one of the preceding claims, **characterized in that** the optical or electronic component (1) is arranged on a carrier (3) before the encapsulation.

13. Method according to Claim 12, **characterized in that** the carrier takes the form of a leadframe (3), which has on the one hand at least one planar carrier region (32) and on the other hand a plurality of contact leads (31), which are located at the edge region of the leadframe, the optical or electronic component (1) being respectively arranged on a carrier region (32).

14. Method according to at least one of the preceding claims, **characterized in that** the step of encapsulating comprises embedding or press-moulding the at least one component (1) with the at least one polymer material.

15. Optical module with
- at least one optical or electronic component (1), which has an operative region (11), via which it emits or detects light of a specific wavelength,
- a protective layer (12), which is applied to the component (1) and covers at least the operative region (11) of the component, and
- a plastic package (4), in which the component (1) is arranged,
- the plastic package (4) having adjacent the protective layer (12) a laser-ablated opening (9) and the operative region (11) of the component (1) being in operative connection with the surroundings via the laser-ablated opening (9), and
- the protective layer (12) being formed so as to be reflective for radiation of the wavelength with which a laser ablation device (13) has formed the laser-ablated opening (9) in the plastic package (4) and transparent for light of the wavelength emitted or detected by the optical component.

16. Module according to Claim 15, **characterized in that** the protective layer (12) is formed by a system of layers which forms an interference filter.

17. Module according to at least one of Claims 15 or 16, **characterized in that** the protective layer (12) is formed by at least one metal layer or at least one plastic layer.

## Revendications

1. Procédé de fabrication d'un module électronique ou optique muni d'un boîtier en matière plastique, comprenant les étapes suivantes :
- Mise à disposition d'au moins un composant optique (1), présentant une zone active (11), au moyen de laquelle il émet ou détecte de la lumière ayant une longueur d'onde déterminée, dans le module fini de fabrication,
- application sur le composant (1) d'une couche de protection (12), recouvrant au moins la zone active (11) du composant (1),
- enrobage du au moins un composant (1) par au moins une composition de matière plastique (40) servant à réaliser le boîtier en matière plastique (4), et
- enlèvement partiel de la composition de matière plastique (40), de l'extérieur, au moyen d'un dispositif d'enlèvement de matière au laser (13), de manière à enlever la composition de matière plastique (40) se trouvant entre la couche de protection (12) du composant (1) et la face extérieure du boîtier en matière plastique (4), afin de créer une ouverture par enlèvement de matière au laser,
- la couche de protection (12), qui réfléchit le rayonnement émis par le dispositif d'enlèvement de matière au laser (13), étant cependant transparente à une lumière ayant la longueur d'onde émise ou détectée par le composant optique et
- la couche de protection (12) restant sur le composant (1) après enlèvement partiel de la composition de matière plastique (40).

2. Procédé selon la revendication 1, **caractérisé en ce que** la vitesse d'enlèvement de matière au laser de la couche de protection (12) est inférieure à la vitesse d'enlèvement de matière au laser de la composition de matière plastique (40) du boîtier en matière plastique.

3. Procédé selon la revendication 1, **caractérisé en ce que** le composant (1) est un composant émetteur optoélectronique, dans lequel la couche de protection (12) est transparente de la lumière ayant la longueur d'onde émise, tout en réfléchissant le rayonnement émis par le dispositif d'enlèvement de matière au laser (13).

4. Procédé selon la revendication 1, **caractérisé en ce que** le composant (1) est un composant récepteur optoélectronique, dans lequel la couche de protection (12) est transparente à de la lumière ayant la longueur d'onde à détecter, tout en réfléchissant le rayonnement émis par le dispositif d'enlèvement de matière au laser (13).

5. Procédé selon au moins l'une des revendications 1 à 4, **caractérisé en ce que** la longueur d'onde émise ou détectée est de l'ordre de 650 nm, 850 nm, 1310 nm ou 1550 nm.

6. Procédé selon au moins l'une des revendications 1 à 4, **caractérisé en ce que** le rayonnement émis par le dispositif d'enlèvement de matière au laser (13) présente une longueur d'onde de l'ordre de 1064 nm.

7. Procédé selon au moins l'une des revendications 1 à 6, **caractérisé en ce que** le rayonnement réfléchi par la couche de protection (12) est détecté et qu'à partir du rayonnement détecté est déduit un signal, provoquant l'arrêt de l'enlèvement de la composition de matière plastique par le dispositif d'enlèvement de matière au laser (13).

8. Procédé selon au moins l'une des revendications précédentes, **caractérisé en ce que** la couche de protection (12) est appliquée sur une tranche, avant que celle-ci ne soit découpée avec la formation de composants électroniques ou optiques (1).

9. Procédé selon au moins l'une des revendications 1 à 8, **caractérisé en ce que** la couche de protection (12) est déposée sur les composants (1) individuels, sinon pré-fabriqués.

10. Procédé selon au moins l'une des revendications précédentes, **caractérisé en ce que** l'on utilise un système de couches, constituant un filtre interférentiel, en tant que couche de protection (12).

11. Procédé selon au moins l'une des revendications précédentes, **caractérisé en ce qu'**au moins une couche métallique ou au moins une couche en matière plastique est utililsée en tant que couche de protection (12).

12. Procédé selon au moins l'une des revendications précédentes, **caractérisé en ce que** le composant électronique ou optique (1) est disposé sur un support (3) avant son enrobage.

13. Procédé selon la revendication 12, **caractérisé en ce que** le support (3) est réalisé en tant que leadframe, présentant d'une part au moins une zone support (32) plane et d'autre part une pluralité de broches de contact (31) se trouvant dans la zone de bordure du leadframe, et **en ce que** le composant électronique ou optique (1) est disposé respectivement sur une zone support (32).

14. Procédé selon au moins l'une des revendications précédentes, **caractérisé en ce que** l'étape d'enrobage comprend une coulée ou une injection sous pression d'au moins un composant (1) avec la au moins une matière plastique.

15. Module optique comprenant
- au moins un composant électronique ou optique (1), présentant une zone active (1), au moyen de laquelle il émet ou détecte de la lumière ayant une longueur d'onde déterminée,
- une couche de protection (12) appliquée sur le composant (1) et recouvrant au moins la zone active (11) du composant, et
- un boîtier en matière plastique (4), dans lequel est disposé le composant (1),
- le boîtier en matière plastique (4) présentant une ouverture par enlèvement de matière au laser (9) adjacente à la couche de protection (12), et la zone active (11) du composant (1) étant en liaison fonctionnelle avec ce qu'il l'entoure, par l'intermédiaire de l'ouverture par enlèvement de matière au laser (9), et
- la couche de protection (12) étant réalisée de manière à réfléchir un rayonnement présentant la longueur d'onde permettant à un dispositif d'enlèvement de matière au laser (13) de réaliser l'ouverture par enlèvement de matière au laser (9) dans le boîtier en matière plastique (4), et de manière transparente à une lumière présentant la longueur d'onde émise ou détectée par le composant optique.

16. Module selon la revendication 15, **caractérisé en ce que** la couche de protection (12) est formée d'un système de couches, constituant un filtre interférentiel.

17. Module selon au moins l'une des revendications 15 ou 16, **caractérisé en ce que** la couche de protection (12) est formée par au moins une couche métallique ou au moins une couche en matière plastique.
